Europäisches Patentamt

European Patent Office

Office européen des brevets

(11) Publication number: **0 444 901 A2**

# EUROPEAN PATENT APPLICATION

(21) Application number: **91301593.9**

(22) Date of filing: **27.02.91**

(51) Int. Cl.$^5$: **H01L 39/12**

(30) Priority: **27.02.90 US 485562**

(43) Date of publication of application:
**04.09.91 Bulletin 91/36**

(84) Designated Contracting States:
**AT BE CH DE DK ES FR GB GR IT LI LU NL SE**

(71) Applicant: **UNIVERSITY OF ARKANSAS**
**P.O. Box 3017**
**Little Rock, Arkansas 72203 (US)**

(72) Inventor: **Sheng, Zhengzhi, Dr.**
**Carlson Terrace, University of Arkansas**
**Fayetteville, Arkansas 72701 (US)**
Inventor: **Hermann, Allen M., Dr.**
**2704 Lookout View Drive Golden**
**Colorado 80481 (US)**

(74) Representative: **Sheard, Andrew Gregory et al**
**Kilburn & Strode 30, John Street**
**London WC1N 2DD (GB)**

(54) **Tl-Ba-Ca-Cu-O superconducting materials having levitating properties and processes for their preparation.**

(57) A superconducting material that exhibits unusual levitating properties, and methods for making it, are provided. The material is in the Tl-Ba-Ca-Cu-O system. The methods comprise the steps of heating a material consisting of thallium, barium, calcium, and copper components and annealing the resultant product.

FIGURE 1

EP 0 444 901 A2

# TI-Ba-Ca-Cu-O SUPERCONDUCTING MATERIALS HAVING UNUSUAL LEVITATING PROPERTIES AND PROCESSES FOR THEIR PREPARATION

The present invention relates to high temperature superconductors. More specifically, the present invention relates to high temperature superconducting systems based on a material having the general composition thallium (Tl); barium (Ba); calcium (Ca); copper (Cu); oxygen (O) and process for making such systems.

A variety of superconducting systems are known. One such system is the Tl-Ba-Ca-Cu-O system. EP-A-0324660, having the same inventors as in the present application, discloses Tl-Ba-Ca-Cu-O superconductors and methods for making them.

Although the above-identified patent application discloses Tl-Ba-Ca-Cu-O superconductors which the present Applicants believe have among the highest transition temperatures to date, a new superconducting material in the same system would be desirable for may reasons. Such a superconducting material could provide improved or novel properties. Moreover, such a superconducting material could: (1) facilitate the discovery of the correct theory on oxide superconductivity; (2) provide a framework for the search for higher temperature, even room temperature superconductors; (3) allow superconducting components to operate in an unique way; and (4) provide low cost processing and manufacturability of superconductors.

According to a first aspect of the present invention there is provided a process for the preparation of a compound, which is a high temperature superconductor material that may demonstrate unusual levitating properties, without doping, the compound having the following general formula (and approximate nominal stoichiometry):

$$TlBa_yCa_zCu_uO_v$$

wherein y is greater than or equal to 0.25 and less than or equal to 2;

z is greater than or equal to 0.5 and less than or equal to 6;

u is greater than or equal to 0.5 and less than or equal to 7.5; and

v is greater than or equal to $y + z + u$ and less than or equal to $2 + y + z + u$;

the process comprising annealing a compound of the general formula:

$$TlBa_yCa_zCu_uO_v.$$

Such annealing will generally be provided in a step during which a $TlBa_yCa_zCu_uO_v$ material is annealed.

Preferred compounds that are prepared include $Tl_2Ba_2Ca_2Cu_3O_{10}$, $Tl_2BaCa_3Cu_4O_{11}$ or $Tl_2BaCa_3Cu_3O_{10}$.

The annealing preferably takes place after the compound of the formula $TlBa_yCa_zCu_uO_v$ is formed

and after the compound has been cooled after a preferred heating stage.

Annealing is suitably conducted at a temperature of from 650 to 850°C, such as from 700 to 800°C. It is suitably carried out in the presence of flowing oxygen, for example for from 2 to 24 hours. During annealing the compound is preferably in the form of a pellet.

A second aspect of the present invention relates to a compound (which may also have unusual levitating properties) having the following general formula:

$$Tl-Ba-Ca-Cu-O-X$$

wherein X represents mercury (Hg), silver (Ag), indium (In), strontium (Sr), magnesium (Mg) or potassium (K). Preferably X represents mercury, silver, strontium, magnesium or potassium. Silver, and in particular mercury, are preferred.

A third aspect of the present invention relates to a process for the preparation of a (high temperature) superconducting material, that may have unusual levitating properties, the process comprising:

(a) mixing (and preferably grinding) a barium, a calcium, and a copper compound (for example to make a barium, calcium, copper oxide powder);

(b) heating the resultant mixture with a thallium compound; and

(c) annealing the resultant product (b).

Preferred compounds of barium, calcium and copper include carbonates or oxides, although a carbonate is preferred for barium while an oxide is preferred for the calcium and copper compounds.

The thallium compound is suitably the oxide, $Tl_2O_3$. The thallium compound is preferably added to the mixture of barium, calcium and copper compound mixture that has been heated, such as about 925°C for at least 24 hours (although it may be added into the barium, calcium and copper compound mixture and then all four compounds are annealed).

The barium, calcium and copper mixture (which is preferably an oxide mixture and usually a powder) preferably has the following approximate stoichiometries: $Ba_2Ca_2Cu_3O_7$; $BaCa_3Cu_4O_8$ or $BaCa_3Cu_3O_7$.

Suitably the barium, calcium and copper mixture is heated prior to stage (b). The mixture and thallium compound are suitably heated (or annealed) in flowing oxygen.

It is advantageous that the process involves mixing and grinding an amount of the mixture in (a) and the thallium compound together and pressing them into a pellet before heating.

A preferred process comprises:

(a) grinding and mixing barium carbonate, calcium oxide and copper oxide into a mixture, such as a powder;

(b) heating the mixture, such as a powder, at approximately 925°C for approximately 24 hours;

(c) mixing the mixture, such as a powder, with thallium oxide, and then pressing it into a pellet;

(d) heating the pellet, for example in a tube furnace, at from 950°C to 1000°C, for example once placed on a platinum sheet, in flowing oxygen, such as for 2 to 10 minutes;

(e) removing the pellet (and preferably also the platinum sheet) from the furnace and cooling it in air; and

(f) annealing a re-solidified pellet in flowing oxygen from 700°C to 800°C for 2 to 24 hours.

It will thus be appreciated that after the initial heating stage of the barium, calcium and copper mixture, the resultant heated mixture is allowed to solidify before annealing.

If compounds of Tl-Ba-Ca-Cu-O-X are to be made, then a compound of X may be introduced into the process before annealing(for example, in (a) or (c)) above. Suitably the compound of X is introduced with the thallium compound. Preferred compounds of X include the oxides and in particular mercury oxide (HgO).

The product of (f) may be furnace cooled after annealing.

In a preferred embodiment the process comprises:

(a) grinding and mixing barium carbonate, calcium oxide and copper oxide to make a mixture, such as a powder;

(b) heating the mixture, such as a powder;

(c) mixing the mixture of (b) with a thallium compound and pressing it into a pellet;

(d) placing the pellet on a platinum sheet (such as in a tube furnace) and heating it in flowing oxygen, such as from 950°C to 1000°C for from 2 to 10 minutes;

(e) removing the pellet from the heat and cooling the pellet in air; and

(f) annealing the re-solidified pellet in flowing oxygen at from 700°C to 800°C for approximately 2 to 24 hours, and allowing the pellet to cool.

The heating in (b) is suitably at about 925°C for approximately 24 hours. In (e), the pellet may be placed on a platinum sheet which is heated to the same temperature as the pellet. The pellet may then be removed from the heat as soon as it has melted, or as soon as it has partially melted.

In preferred processes (a), (b) and (c) are conducted by mixing, grinding and pelletising the thallium, barium, calcium and copper compounds. These compounds are preferably thallium oxide, barium oxide, calcium and copper oxide.

Preferred features and characteristics of one aspect of the invention are as for another aspect *mutatis mutandis.*

The present invention thus provides a new superconducting material and a process for its preparation. The material can have a transition temperature of above 100K. The superconducting material may be levitated above, to the side of, or beneath, a magnet. This unusual levitation is unique among high temperature superconducting materials.

The high temperature superconductor system of the present invention thus comprises a system containing elements:

Tl-Ba-Ca-Cu-O

although the superconducting system preferably comprises the following elements:

Tl-Ba-Ca-Cu-O-X

wherein:

X is Hg, Ag, In, Sr, Mg or K. X is not essential, but may be useful to stabilise certain high Tc phases.

In a preferred embodiment, the compound of the present application, being a levitating material, has the following approximate (nominal) stoichiometry:

$TlBa_yCa_zCu_uO_v.$

wherein:

y is greater than or equal to 0.25 and less than or equal to 2;

z is greater than or equal to 0.5 and less than or equal to 6;

u is greater than or equal to 0.5 and less than or equal to 7.5; and

v is greater than or equal to y + z + u and less than or equal to 2 + y + z + u.

A process for preparing Tl-Ba-Ca-Cu-O superconducting material having unusual levitating properties is also provided by the present invention. Pursuant to a preferred process a barium-calcium-copper-oxide powder is prepared by mixing and heating barium, calcium, and copper components. The powder is combined with thallium or a thallium compound, for example thallium oxide, and the powder and thallium or thallium compound are heated. The heated product may then be annealed, such as in flowing oxygen.

In a preferred embodiment, the powder and thallium are heated to from 950°C to 1000°C.

The product is preferably annealed at from 700°C to 800°C.

One object of the present invention is to provide a new superconducting material having a high transition temperature.

A further object of the present invention is to provide a superconducting material that can be levitated above, to the side of, or beneath, a magnet.

An advantage of the present inventions that it may provide a material that exhibits unusual levitation properties at temperatures above liquid nitrogen.

A still further advantage of the present invention is that it may provide a new high temperature material having unusual levitating properties that can be rapidly fabricated by melting.

Furthermore, an advantage of the present invention is that it may provide a method for making the new high temperature material, that has unusual levitating properties, in arbitrary shapes.

Moreover, an advantage of the present invention is that it may provide a superconducting system that can produce superconductors that can be levitated above, to the side of, or beneath a magnet at temperatures above the temperature of liquid nitrogen without doping.

Additional features and advantages of the present invention are described in, and will be apparent from, the detailed description of the presently preferred embodiments and from the drawings.

The present invention thus provides a new superconducting material encompassed in the Tl-Ba-Ca-Cu-O system having unusual levitation properties. To this end, the material can be levitated above, to the side of, or beneath a magnet at temperatures above liquid nitrogen temperature. The present invention also provides processes for preparing such materials.

It is known that a high temperature superconductor can be levitated above a magnet. In this regard, it has been found that $YBa_2Cu_3O_{7-x}$, when doped with AgO, can be levitated beneath a magnet. The inventors in the present application have found that compounds in the Tl-Ba-Ca-Cu-O system, without doping, that may be made pursuant to the processes of the present invention, can be levitated above, to the side of, or beneath, a magnet at temperatures above the temperature of liquid nitrogen.

The inventors have found that by utilising processes of the present invention a Tl-Ba-Ca-Cu-O material can be prepared that exhibits unusual levitating properties. In this regard, preparing a superconducting material pursuant to the processes of the present invention, e.g. through melting, quenching, and annealing can create a resultant product that exhibits unusual levitation properties. Since this material having the unusual levitation properties can be prepared by melting, the material can be rapidly produced, and can be easily construed into arbitrary shapes.

The present invention encompasses a system having the general formula:

thallium-barium-calcium-copper-oxygen-X

wherein X is an element which may not be required, but when present may be useful to stabilise certain high Tc phases. Preferably, X is mercury (Hg) or silver (Ag).

This compound can be prepared pursuant to a process of the present invention. In a preferred embodiment, the process comprises:

mixing and heating barium, calcium and copper components (whether in the form of elements or compounds);

combining this heated mixture (e.g. powder) with a thallium containing component;

heating the mixture (e.g. powder) and thallium containing component; and

annealing the resultant product in flowing oxygen.

The invention will now be described by way of examples, with reference to the accompanying drawings and following Examples, which are provided by way of illustration and are not to be construed as being limiting.

Figure 1(a) and (b) are two photographs illustrating the unusual levitating properties of a compound, which is a superconductor, of the present invention;

Figure 2 is a graph of electrical resistance versus temperature for three compounds:

1. a $Tl_2Ba_2Ca_2Cu_3O_{10}$ melt sample (2223A) that was prepared without an annealing process step;

2. a $Tl_2Ba_2Ca_2Cu_3O_{10}$ melt sample (2233B) prepared using a process of the present invention; and

3. a $Tl_2BaCa_3Cu_4O_{10}$ melt sample (2134) prepared using a process of the present invention; and

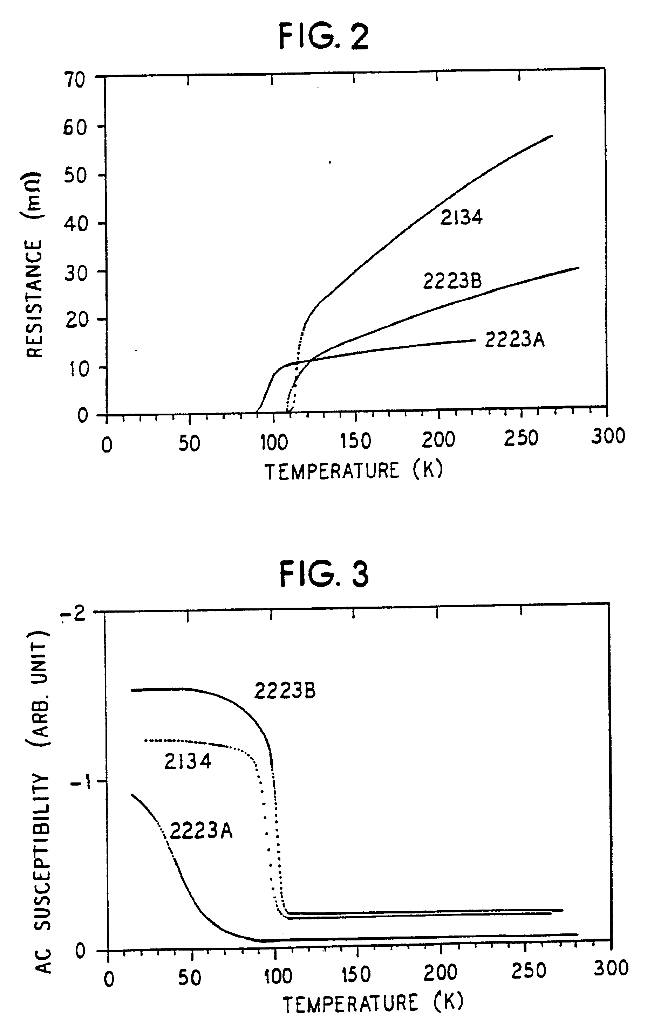

Figure 3 is a graph of ac susceptibility versus temperature for the sample 2223A, 2223B, and 2134 depicted in Figure 2.

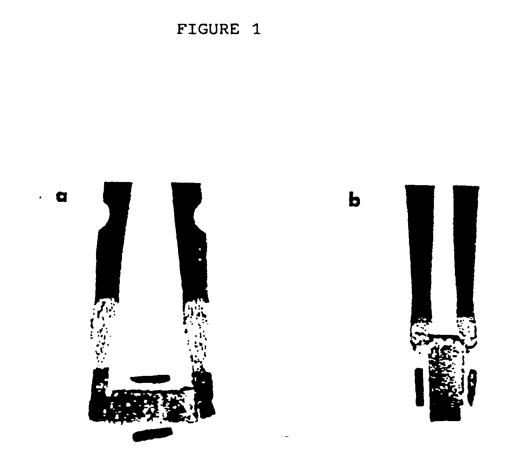

Referring further to Figure 1, photographs illustrating the unusual levitating properties of compounds of the present invention are provided. Figure 1(a) illustrates the levitation of two Tl-Ba-Ca-Cu-O samples according to the present invention. As illustrated, the levitation is above and below a magnet. Figure 1(b) illustrates the levitation of two Tl-Ba-Ca-Cu-O samples, also according to the present invention. As illustrated, the levitation is to either side of a magnet.

By way of example and not limitation, examples of the Tl-Ba-Ca-Cu-O material having unusual levitating properties and methods for making them will now be given.

Example 1:

A. The following reagents were utilised:
   1. $Tl_2O_3$,
   2. CaO,
   3. $BaCO_3$, and
   4. CuO.
B. The following procedure was followed:
   1. A mixture of a two molar portion of $BaCO_3$, a two molar portion of CaO, and a three molar portion of CuO was ground with an agate mortar and pestle. The ground mixture was heated in air at approximately 925°C for more than 24 hours (with several intermediate grindings) to obtain a uniform black powder with a nominal composition of $Ba_2Ca_2Cu_3O_7$.
   2. Amounts of $Tl_2O_3$ and $Ba_2Ca_2Cu_3O_7$ at a molar ratio of 1:1 were mixed, ground, and pressed into a pellet.
   3. The resultant pellet was then placed on a platinum sheet, which was then placed in a quartz boat.
   4. The quartz boat and its contents were then heated at approximately 950°C to about 1000°C in a tube furnace for approximately 2 to about 10 minutes in flowing oxygen.

5. As soon as the pellet had melted, the quartz boat was removed from the furnace and cooled in air to room temperature. It should be noted that the boat could have been taken out after the pellet was partially melted.

6. The re-solidified pellet was then removed from the platinum sheet, and annealed in a tube furnace at approximately 700°C to about 800°C for approximately 2 to about 24 hours in flowing oxygen. This was followed by a furnace cooling.

The samples prepared by this procedure demonstrated unusual leviation properties. The samples had a nominal composition of $Tl_2Ba_2Ca_2Cu_3O_{10}$ and an onset temperature of above 120 K and a zero resistance temperature of above 100 K.

Figure 2 illustrates resistance as a function of temperature for the $Tl_2Ba_2Ca_2Cu_3O_{10}$ sample (sample 2223B) prepared pursuant to this example. 2223A illustrates resistance-temperature dependence of a sample having a similar nominal composition as sample 2223B, but that was created utilizing a method that did not include an annealing step. Figure 3 illustrates ac susceptibility as a function of temperature of the samples 2223A and 2223B.

EXAMPLE 2:

A. The following reagents were utilized:
    1. $Tl_2O_3$,
    2. CaO,
    3. $BaCO_3$, and
    4. CuO.
B. The following procedure was followed:
    1. A mixture of a one molar portion of $BaCO_3$, a three molar portion of CaO, and a four molar portion of CuO was ground with an agate mortar and pestle. The ground mixture was then heated in air at approximately 925°C for more than 24 hours (with several intermediate grindings) to obtain a uniform black powder with a nominal composition of $BaCa_3Cu_4O_8$.
    2. Amounts of $Tl_2O_3$ and $BaCa_3Cu_4O_8$ at a molar ratio of 1:1 were mixed, ground, and pressed into a pellet.
    3. The resultant pellet was then placed on a platinum sheet, which was then placed in a quartz boat.
    4. The quartz boat and its contents were then heated at approximately 950°C to about 1000°C in a tube furnace for approximately 2 to about 10 minutes in flowing oxygen.
    5. As soon as the pellet had melted, the quartz boat was removed from the furnace and cooled in air to room temperature. Again, it should be noted that the boat could have been removed after the pellet had partially melted.
    6. The re-solidified pellet was then removed from the platinum sheet. The pellet was then annealed in a tube furnace at approximately 700°C to about 800°C for approximately 2 to about 24 hours in flowing oxygen. This was followed by a furnace cooling.

The samples prepared pursuant to this example demonstrated unusual levitation properties. The samples had a nominal composition of $Tl_2BaCa_3Cu_4O_{11}$, and an onset temperature of above 120 K and a zero resistance temperature of above 100 K.

Figure 2 illustrates resistance as a function of temperature for a $Tl_2BaCa_3Cu_4O_{11}$ sample (sample 2134) made pursuant to this example. In Figure 3, the ac susceptibility as a function of temperature for sample 2134 is illustrated.

EXAMPLE 3:

A. The following reagents were utilized:
    1. $Tl_2O_3$,
    2. CaO,
    3. $BaCO_3$, and
    4. CuO.
B. The following procedure was followed:
    1. A mixture of a one molar portion of $BaCO_3$, a three molar portion of CaO, and a three molar portion of CuO was ground with an agate mortar and pestle. The ground mixture was then heated in air at approximately 925°C for more than 24 hours (with several intermediate grindings) to obtain a uniform black powder with a nominal composition of $BaCa_3Cu_3O_7$.
    2. Amounts of $Tl_2O_3$ and $BaCa_3Cu_3O_7$ at a molar ratio of 1:1 were mixed, ground, and pressed into a pellet.
    3. The pellet was placed on a platinum sheet, which was then placed in a quartz boat.
    4. The quartz boat and its contents were then heated at approximately 950°C to about 1000°C in a tube furnace for approximately 2 to about 10 minutes in flowing oxygen.
    5. As soon as the pellet had melted (or partially melted), the quartz boat was removed from the furnace and cooled in air to room temperature.
    6. The re-solidified pellet was then removed from the platinum sheet, and annealed in a tube furnace at approximately 700°C to about 800°C for approximately 2 to about 24 hours in flowing oxygen. This was followed by a furnace cooling.

The samples prepared pursuant to this example demonstrated unusual levitation properties, and had an onset temperature of above 120 K and a zero resistance temperature of above 100 K.

EXAMPLE 4:

A. The following reagents were utilized:
1. $Tl_2O_3$,
2. CaO,
3. $BaCO_3$,
4. CuO, and
5. HgO.
B. The following procedure was followed:
1. A mixture of a two molar portion of $BaCO_3$, a two molar portion of CaO, and a three molar portion of CuO was ground with an agate mortar and pestle, heated in air at 925°C for more than 24 hours (with several intermediate grindings) to obtain a uniform black powder with a nominal composition of $Ba_2Ca_2Cu_3O_7$.
2. Amounts of $Tl_2O_3$, HgO, and $Ba_2Ca_2Cu_3O_7$ at a molar ratio of 1/2:1:1 were mixed, ground, and pressed into a pellet.
3. The pellet was then placed on a platinum sheet which was then placed in a quartz boat.
4. The quartz boat and its contents were heated at approximately 950°C to about 1000°C in a tube furnace for approximately 2 to about 10 minutes in flowing oxygen.
5. As soon as the pellet had melted (or partially melted), the quartz boat was removed from the furnace and cooled in air to room temperature.
6. The re-solidified pellet, was removed from the platinum sheet, and annealed in a tube furnace at approximately 700°C to about 800°C for approximately 2 to about 24 hours in flowing oxygen. This was followed by a furnace cooling.

The samples prepared by this procedure demonstrated unusual levitation properties, and had an onset temperature of above 120 K and a zero resistance temperature of above 100 K.

EXAMPLE 5:

A. The following reagents were utilized:
1. $Tl_2O_3$,
2. CaO,
3. BaO, and
4. CuO
B. The following procedure was followed:
1. Amounts of $Tl_2O_3$, BaO, CaO, and CuO at a molar ratio 1:2:2:3 was mixed and ground in an agate mortar. The ground mixture was pressed into a pellet.
2. The resultant pellet was then placed on a platinum sheet, which was then placed in an alumina boat.
3. The alumina boat and its contents were then heated at approximately 950°C to about 1000°C in a preheated tube furnace for approximately 2 to about 10 minutes in flowing oxygen.
4. As soon as the pellet had melted (or partial melted), the alumina boat was removed from the furnace and cooled in air to room temperature.
5. The re-solidified pellet was then removed from the-platinum sheet. The pellet was then annealed in a tube furnace at approximately 700°C to about 800°C for approximately 2 to about 24 hours in flowing oxygen. This was followed by a furnace cooling.

The samples prepared pursuant to this example demonstrated unusual levitation properties. The sample had a nominal composition of $Tl_2Ba_2Ca_2Cu_3O_{10}$, and an onset temperature of above 120 K and a zero resistance temperature of above 100 K.

It should be understood that various changes and modifications to the presently preferred embodiments described herein will be apparent to those skilled in the art. Such changes and modifications can be made without departing from the spirit and scope of the present invention and without diminishing its attendant advantages. It is therefore intended that such changes and modifications be covered by the appended claims.

**Claims**

1. A process for the preparation of a compound of the general formula:

$$TlBa_yCa_zCu_uO_v$$

wherein:
y is greater than or equal to 0.25 and less than or equal to 2;
z is greater than or equal to 0.5 and less than or equal to 6;
u is greater than or equal to 0.5 and less than or equal to 7.5; and
v is greater than or equal to y + z + u and less than or equal to 2 + y + z + u;
the process comprising annealing a compound of the general formula:

$$TlBa_yCa_zCu_uO_v.$$

2. A process as claimed in claim 1 for preparing a compound of the formula $Tl_2Ba_2Ca_2Cu_3O_{10}$, $Tl_2BaCa_3Cu_4O_{11}$ or $Tl_2BaCa_3Cu_3O_{10}$.

3. A compound having the following general formula:

Tl-Ba-Ca-Cu-O-X

wherein X represents Hg, Ag, In, Sr, Mg, or K.

4. A compound as claimed in claim 3 wherein X represents Hg or Ag.

5. A process for the preparation of a superconducting material, the process comprising:
   (a) mixing a barium, a calcium, and a copper compound;
   (b) heating the resultant mixture with a thallium compound; and
   (c) annealing the resultant product of (b).

6. A process as claimed in claim 5 wherein the thallium compound is $Tl_2O_3$.

7. A process as claimed in claim 5 or 6 wherein the barium, calcium, copper mixture has an approximate stoichiometry of $Ba_2Ca_2Cu_3O_7$; $BaCa_3Cu_4O_8$; or $BaCa_3Cu_3O_7$.

8. A process as claimed in any of claims 5 to 7 wherein the barium, calcium and copper compounds are all oxides.

9. A process as claimed in any of claims 5 to 8 wherein the mixture and thallium are annealed in (c) in flowing oxygen.

10. A process as claimed in any of claims 5 to 9 wherein (b) involves mixing and grinding an amount of the mixture in (a) and the thallium compound together, and pressing into a pellet before heating.

11. A process as claimed in any of claims 5 to 10 comprising:
    (a) grinding and mixing $BaCO_3$, CaO, and CuO to make a mixture, such as in the form of a powder;
    (b) heating the mixture, such as at about 925°C for about 24 hours;
    (c) mixing (b) with a thallium compound and pressing it into a pellet;
    (d) placing the pellet on a platinum sheet (such as in a tube furnace) and heating it in flowing oxygen such as from 950°C to 1000°C for from 2 to 10 minutes;
    (e) removing the pellet from the heat and cooling the pellet in air; and
    (f) annealing the re-solidified pellet in flowing oxygen at from 700°C to 800°C for 2 to 24 hours, and allowing to cool.

12. A process as claimed in any of claims 5 to 11 additionally including in (c) mixing in a compound of X wherein X represents Hg, Ag, In, Sr, Mg or K, such as HgO.

13. A process as claimed in claim 11 or 12 wherein (a), (b) and (c) are conducted by mixing, grinding, and pelletising the thallium, barium, calcium, and copper compounds.

14. A process as claimed in claim 14 wherein the compounds are $Tl_2O_3$, BaO, CaO, and CuO.

15. A compound prepared by a process as claimed in any of claims 1, 2 or 5 to 14.

**Claims for the following Contracting State: ES**

1. A process for the preparation of a compound of the general formula:
   $$TlBa_yCa_zCu_uO_v$$
   wherein:
   y is greater than or equal to 0.25 and less than or equal to 2;
   z is greater than or equal to 0.5 and less than or equal to 6;
   u is greater than or equal to 0.5 and less than or equal to 7.5; and
   v is greater than or equal to $y + z + u$ and less than or equal to $2 + y + z + u$;
   the process comprising annealing a compound of the general formula:
   $$TlBa_yCa_zCu_uO_v.$$

2. A process as claimed in claim 1 for preparing a compound of the formula $Tl_2Ba_2Ca_2Cu_3O_{10}$, $Tl_2BaCa_3Cu_4O_{11}$ or $Tl_2BaCa_3Cu_3O_{10}$.

3. A process for the preparation of a compound having the following general formula:
   $$Tl-Ba-Ca-Cu-O-X$$
   wherein X represents Hg, Ag, In, Sr, Mg, or K, the process comprising admixing a compound of thallium, a compound of barium, a compound of calcium, a compound of copper and a compound of X and heating where necessary.

4. A process as claimed in claim 3 wherein X represents Hg or Ag.

5. A process for the preparation of a superconducting material, the process comprising:
   (a) mixing a barium, a calcium, and a copper compound;
   (b) heating the resultant mixture with a thallium compound; and
   (c) annealing the resultant product of (b).

6. A process as claimed in claim 5 wherein the thallium compound is $Tl_2O_3$.

7. A process as claimed in claim 5 or 6 wherein the barium, calcium, copper mixture has an

approximate stoichiometry of $Ba_2Ca_2Cu_3O_7$; $Ba-Ca_3Cu_4O_8$; or $BaCa_3Cu_3O_7$.

8. A process as claimed in any of claims 5 to 7 wherein the barium, calcium and copper compounds are all oxides.

9. A process as claimed in any of claims 5 to 8 wherein the mixture and thallium are annealed in (c) in flowing oxygen.

10. A process as claimed in any of claims 5 to 9 wherein (b) involves mixing and grinding an amount of the mixture in (a) and the thallium compound together, and pressing into a pellet before heating.

11. A process as claimed in any of claims 5 to 10 comprising:
    (a) grinding and mixing $BaCO_3$, $CaO$, and $CuO$ to make a mixture, such as in the form of a powder;
    (b) heating the mixture, such as at about 925°C for about 24 hours;
    (c) mixing (b) with a thallium compound and pressing it into a pellet;
    (d) placing the pellet on a platinum sheet (such as in a tube furnace) and heating it in flowing oxygen such as from 950°C to 1000°C for from 2 to 10 minutes;
    (e) removing the pellet from the heat and cooling the pellet in air; and
    (f) annealing the re-solidified pellet in flowing oxygen at from 700°C to 800°C for 2 to 24 hours, and allowing to cool.

12. A process as claimed in any of claims 5 to 11 additionally including in (c) mixing in a compound of X wherein X represents Hg, Ag, In, Sr, Mg or K, such as HgO.

13. A process as claimed in claim 11 or 12 wherein (a), (b) and (c) are conducted by mixing, grinding, and pelletising the thallium, barium, calcium, and copper compounds.

14. A process as claimed in claim 14 wherein the compounds are $Tl_2O_3$, $BaO$, $CaO$, and $CuO$.

FIGURE 1

EP 0 444 901 A2

# FIG. 2

# FIG. 3